# EUROPEAN PATENT APPLICATION

(11) **EP 4 701 082 A2**
(43) Date of publication of application: **25.02.2026**
(21) Application number: 24792870.8
(22) Date of filing: 25.03.2024
(51) Int. Cl.: H03K 19/177, G04F 10/00

(54) **TDC FOR ENHANCING TIME RESOLUTION, AND FPGA INCLUDING SAME**

(30) Priority: 21.04.2023 KR 20230052773
(71) Applicant: SDT Inc., Seoul 06211 (KR)
(72) Inventor: PARK, Byung Kwon, Suwon-si Gyeonggi-do 16238 (KR); YUNE, Jiwon, Gwacheon-si Gyeonggi-do 13839 (KR)
(74) Representative: M. Zardi & Co S.A.
(86) International application number: PCT/KR2024/003677
(87) International publication number: WO 2024/219683

(57) **Abstract**

an FPGA including a first delay line part to which an input pulse having a width corresponding to a time difference between generation times of a start signal and a stop signal is inputted; a code conversion part that converts and outputs an order of elements of a thermometer code outputted from the first delay line part; and a calculation part that determines the generation time difference using a conversion code outputted from the code conversion part, wherein the conversion code is an arrangement of an order of elements of the thermometer code according to a predetermined criterion, and the predetermined criterion is a data path delay from an output node of the input pulse to output nodes of each of a plurality of flip-flops included in the first delay line part.

## Description

### Technical Field

The present invention relates to TDC technology for FPGAs, and more particularly to TDC technology capable of improving time resolution.

### Background Art

TDC (Time-to-Digital Converter) is a device or circuit that converts the time interval between two events into a digital output. TDCs play an important role in many scientific and industrial applications where precise timing measurement is required. They are widely used in applications requiring high-precision timing measurements, such as time-of-arrival (TOF) measurement in particle physics, medical imaging, radar systems, and laser rangefinders. A TDC operates by measuring the time difference between two events, such as signal arrival or signal emission and reflection, at two points within a circuit. Typically, a counter is used to count the number of clock cycles between two events. This count is then converted into a digital output representing the time interval. There are various types of TDCs, such as leading edge TDCs, trailing edge TDCs, and interpolation TDCs. Leading edge TDCs measure the time between the leading edge of a start signal and the leading edge of a stop signal, while trailing edge TDCs measure the time between the trailing edge of a start signal and the trailing edge of a stop signal. Interpolation TDCs increase the resolution of the TDC by estimating the time interval between two clock cycles using interpolation techniques.

TDCs can be implemented using ASICs (Application-Specific Integrated Circuits), MCUs (Microcontrollers), PSoCs (Programmable System-on-Chip), DSPs (Digital Signal Processors), FPAAs (Field Programmable Analog Arrays), TACs (Time-to-Amplitude Converters), TFCs (Time-to-Frequency Converters), and FPGAs (Field Programmable Gate Arrays).

There can be several problems when implementing a TDC using an FPGA. First, the resources available in the FPGA, including logic cells, look-up tables (LUTs), and routing channels, are limited, which may limit the resolution and accuracy of the TDC implemented in the FPGA. Second, jitter at high clock frequencies can introduce errors in the TDC measurement. Jitter here refers to variations in the timing of the clock signal due to factors such as noise and temperature. Third, the TDC may exhibit non-linear behavior due to factors such as voltage drop, temperature variations, and manufacturing process variations, which can cause errors in TDC measurements at high resolutions. Fourth, FPGAs have delays due to signal processing and routing. These delays can introduce errors in TDC measurements for small time intervals.

In FPGAs, routing refers to the process of connecting programmable logic elements (e.g., look-up tables, flip-flops, and multiplexers) on the chip to form the desired logic circuit. Routing determines how signals propagate through the chip and can significantly affect the overall performance of the design. One of the main factors that can cause delay in FPGA routing is the capacitance of the interconnect wires connecting the logic elements. As the number of logic elements and the distance between them increases, the capacitance of the interconnect wires also increases. This capacitance can delay the propagation of signals through the wires, increasing the overall delay of the design. Another factor that can cause delay in FPGA routing is routing congestion. When the routing resources of an FPGA are limited and the number of logic elements that need to be connected is high, routing congestion occurs. Routing congestion increases the distance between logic elements, increasing the capacitance of the interconnect wires and therefore causing delay.

A tapped delay line is a digital signal processing technique used to implement thermometer codes. In a thermometer code, each bit of a binary number is represented by a separate signal line, and the lines corresponding to "on" bits indicate what the value of the binary number is. To implement a thermometer code using a tapped delay line, a series of delay elements are used to represent each bit. The input binary number is converted into a series of pulses, each pulse representing a 1 bit of the binary number. These pulses are fed into a tapped delay line after being delayed by a different amount depending on the position of each bit. At the output of the tapped delay line, each output signal line represents a bit of the binary number, and the "on" lines represent the value of the binary number. This technique is commonly used in digital-to-analog converters (DACs) to convert digital signals to analog signals.

A carry chain block in an FPGA is a hardware block used to perform fast arithmetic operations, especially addition and subtraction. In digital circuits, the addition and subtraction of numbers with multiple bits requires the calculation of carry bits, which can become a bottleneck in high-speed operations. The carry chain block processes these carry bits efficiently, enabling faster and more efficient arithmetic operations. A carry chain block is generally composed of a series of full adder circuits interconnected in a specific way to form a carry chain. Each full adder circuit calculates one bit of the output and a carry bit to be passed on to the next stage of the chain. By connecting these full adder circuits in a chain, the carry bit can propagate through the chain in one clock cycle, enabling fast addition and subtraction of numbers with multiple bits. In addition to providing fast arithmetic operations, carry chain blocks can also be used to implement counters and other sequential circuits that require the calculation of carry bits.

A timing report tool is a software tool used to analyze the timing performance of a design implemented on an FPGA. The tool generates reports providing information about the timing characteristics of the design. This report includes information about the data path delay, critical paths, setup and hold times, clock skew, and maximum operating frequency of the design. The data path delay is the amount of time it takes for a data signal to propagate through the logic elements of the FPGA.

A multiplexer (Multiplexer), abbreviated as "MUX", is an electronic circuit that selects one of several input signals and passes the selected input to an output line. The input-output structure of a multiplexer generally consists of multiple input lines, selection lines, and one or more output lines. The number of input lines matches the number of input signals the multiplexer can select from, and the selection line determines the selected input signal. For example, a 4-to-1 multiplexer has 4 input lines, 1 output line, and a selection line that determines which of the 4 input signals will be transmitted to the output. The selection line can be controlled by a binary code representing the selected input line. Multiplexers are often used in digital systems to reduce the number of wires required to transmit data and control signals. They are used to implement functions such as data selectors, memory address decoders, and bus allocation circuits.

### Detailed Description of the Invention

### Technical Problem

The present invention aims to provide a TDC and an FPGA including the same that can increase time resolution and compensate for errors caused by jitter.

### Means for Solving the Problems

According to one aspect of the present invention, an FPGA (1) is provided, including: a first delay line part (20) to which an input pulse having a width corresponding to a time difference between the generation times of a start signal and a stop signal is inputted; a code conversion part (30) that converts and outputs the order of elements of a thermometer code outputted from the first delay line part; and a calculation part (60) that determines the generation time difference using a conversion code outputted from the code conversion part, wherein the conversion code is an arrangement of the order of the elements of the thermometer code according to a predetermined criterion, and the predetermined criterion is a data path delay from an output node of the input pulse to output nodes of each of a plurality of flip-flops (FF) included in the first delay line part.

In this case, the FPGA (1) may be programmed to further include a second delay line part to which the input pulse is inputted, and the code conversion part may be configured to generate the conversion code by arranging and merging elements of the thermometer code outputted from the first delay line part and elements of the thermometer code outputted from the second delay line part according to a predetermined second criterion, and the predetermined second criterion may be a data path delay from the output node of the input pulse to output nodes of each of a plurality of flip-flops included in the first delay line part and the second delay line part.

In this case, the FPGA (1) may further include: an input signal generation part (10) that generates an input pulse having a width corresponding to a time difference between a rising edge of the start signal and a rising edge of the stop signal; a clock pulse counting part (40) that counts the number of clock pulses generated during a sustainment period of the input pulse; and the calculation part may further include: a first thermometer code (TC1) outputted by the code conversion part at a rising edge of a first clock pulse among the generated clock pulses, a second thermometer code (TC2) outputted by the code conversion part at a rising edge of a clock pulse generated immediately after a last clock pulse among the generated clock pulses, and a calculation part that determines a value of the generation time difference using the number of counted clock pulses.

According to another aspect of the present invention, an FPGA is provided, including: a plurality of delay line parts to which an input pulse having a width corresponding to a time difference between generation times of a start signal and a stop signal is inputted; a code conversion part that merges and outputs a plurality of thermometer codes outputted from the plurality of delay line parts into one conversion code; and a calculation part that determines the generation time difference using the conversion code, wherein the conversion code is an arrangement of the order of elements of the plurality of thermometer codes according to a predetermined criterion, and the predetermined criterion is a data path delay from an output node of the input pulse to output nodes of each of a plurality of flip-flops in the plurality of delay line parts.

In this case, the FPGA may further include: an input signal generation part that generates an input pulse having a width corresponding to a time difference between a rising edge of the start signal and a rising edge of the stop signal; a clock pulse counting part that counts the number of clock pulses generated during a sustainment period of the input pulse; and the calculation part may further include: a first thermometer code (TC1) outputted by the code conversion part at a rising edge of a first clock pulse among the generated clock pulses, a second thermometer code (TC2) outputted by the code conversion part at a rising edge of a clock pulse generated immediately after a last clock pulse among the generated clock pulses, and a calculation part that determines a value of the generation time difference using the number of counted clock pulses.

According to one aspect of the present invention, a non-transitory computer-readable storage medium is provided, in which an FPGA is programmed to implement a digital circuit including: a first delay line part (20) to which an input pulse having a width corresponding to a time difference between generation times of a start signal and a stop signal is inputted; a code conversion part (30) that converts and outputs the order of elements of a thermometer code outputted from the first delay line part; and a calculation part (60) that determines the generation time difference using a conversion code outputted from the code conversion part, wherein configuration data for programming the FPGA to implement the digital circuit is recorded in a binary file. In this case, the conversion code is an arrangement of the order of elements of the thermometer code according to a predetermined criterion, and the predetermined criterion is a data path delay from an output node of the input pulse to output nodes of each of a plurality of flip-flops (FF) included in the first delay line part.

In this case, the digital circuit may further include: a second delay line part to which the input pulse is inputted, and in the code conversion part, elements of the thermometer code outputted from the first delay line part and elements of the thermometer code outputted from the second delay line part may be arranged and merged according to a predetermined second criterion to generate the conversion code, and the predetermined second criterion may be a data path delay from the output node of the input pulse to output nodes of each of a plurality of flip-flops included in the first delay line part and the second delay line part.

In this case, the digital part may further include: an input signal generation part (10) that generates an input pulse having a width corresponding to a time difference between a rising edge of the start signal and a rising edge of the stop signal; a clock pulse counting part (40) that counts the number of clock pulses generated during a sustainment period of the input pulse; and a first thermometer code (TC1) outputted by the code conversion part at a rising edge of a first clock pulse among the generated clock pulses, a second thermometer code (TC2) outputted by the code conversion part at a rising edge of a clock pulse generated immediately after a last clock pulse among the generated clock pulses, and configuration data for programming the FPGA to implement the digital circuit including a calculation part that determines a value of the generation time difference using the number of counted clock pulses.

According to another aspect of the present invention, a non-transitory computer-readable storage medium is provided, in which an FPGA is programmed to implement a digital circuit including: a plurality of delay line parts to which an input pulse having a width corresponding to a time difference between generation times of a start signal and a stop signal is inputted; a code conversion part that merges and outputs a plurality of thermometer codes outputted from the plurality of delay line parts into one conversion code; and a calculation part that determines the generation time difference using the conversion code, wherein the conversion code is an arrangement of the order of elements of the plurality of thermometer codes according to a predetermined criterion, and the predetermined criterion is a data path delay from an output node of the input pulse to output nodes of each of a plurality of flip-flops in the plurality of delay line parts.

According to one aspect of the present invention, a TDC system is provided, including: a PCB board (100) including the FPGA (1) described above; and a computing device (200) that acquires the generation time difference from the PCB board.

### Effects of the Invention

According to the present invention, it is possible to provide a TDC capable of correcting errors due to jitter and improving time resolution, and an FPGA including the TDC.

### Brief Description of Drawings

FIG. 1 is a configuration diagram of an FPGA according to an embodiment of the present invention.
FIG. 2 is a diagram illustrating an input pulse inputted to a first delay line part according to an embodiment of the present invention.
FIG. 3 illustrates a configuration of the first delay line part according to an embodiment of the present invention.
FIG. 4 is a diagram illustrating indexes of buffers in FIG. 3.
FIG. 5 is a table illustrating data path delays according to an embodiment of the present invention.
FIGS. 6A and 6B are diagrams illustrating a plurality of delay line parts configured in parallel according to an embodiment of the present invention.
FIG. 7A illustrates configurations of the first and second delay line parts in FIG. 6B, and FIG. 7B illustrates operations of a code conversion part when two delay line parts are used, according to an embodiment of the present invention.
FIG. 8 is a graph illustrating delays depending on whether a code conversion part is applied or not, according to an embodiment of the present invention.
FIG. 9 is a diagram illustrating an array criterion of flip-flop output values and an increase value of the number of taps in FIG. 8 depending on whether a code conversion part is applied or not, according to an embodiment of the present invention.
FIG. 10 is a block diagram of a TDC system provided according to an embodiment of the present invention.

### Mode for Invention

Hereinafter, embodiments of the present invention will be described in detail with reference to the accompanying drawings. However, the present invention is not limited to the embodiments described in this specification and can be implemented in various other forms. The terms used in this specification are for the purpose of describing embodiments and are not intended to limit the scope of the present invention. Also, singular forms used herein include plural forms unless explicitly indicated otherwise.

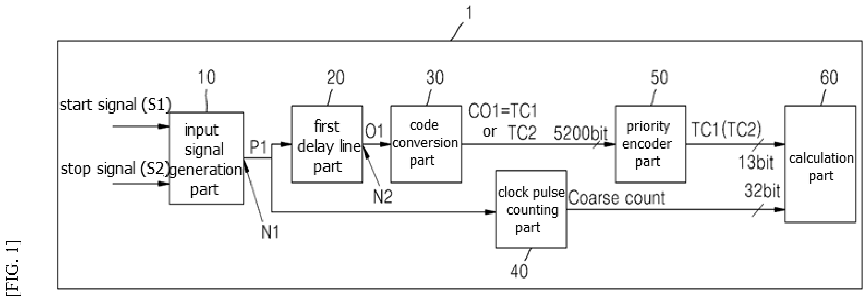

FIG. 1 is a configuration diagram of an FPGA according to an embodiment of the present invention.

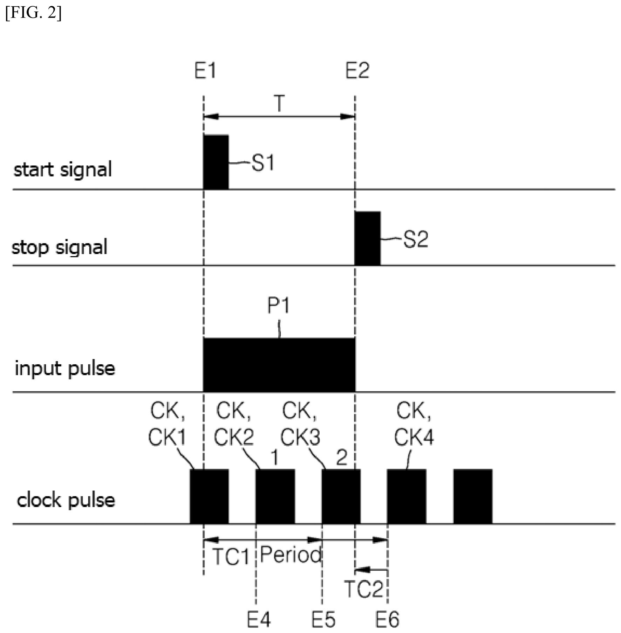

FIG. 2 is a diagram illustrating an input pulse inputted to a first delay line part according to an embodiment of the present invention.

Hereinafter, embodiments will be described in detail with reference to FIGS. 1 and 2 together.

The FPGA (1) may include an input signal generation part (10), a first delay line part (20), a code conversion part (30), a clock pulse counting part (40), a priority encoder part (50), and a calculation part (60).

Specifically, components of the FPGA (1) described above may be components of a TDC (Time to Digital Converter).

As illustrated in FIG. 2, the input signal generation part (10) may generate an input pulse (P1) having a width corresponding to a generation time difference (T) between a rising edge (E1) of a predetermined start signal (S1) and a rising edge (E2) of a predetermined stop signal (S2). The input signal generation part (10) may be configured with logic gates required for the generation.

The first delay line part (20) may receive the input pulse (P1) having a width corresponding to the generation time difference (T) between the start signal (S1) and the stop signal (S2). Then, the first delay line part (20) may output a thermometer code (O1). In this case, the thermometer code may be, for example, an 8-bit value composed of output values of flip-flops included in the first delay line part (20), and each output value of the flip-flops may be referred to as an element of the thermometer code.

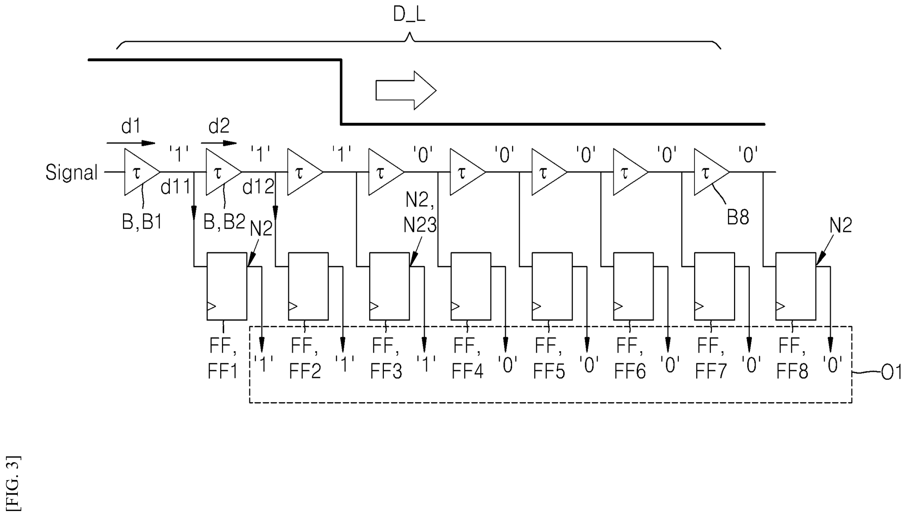

FIG. 3 is a diagram illustrating a configuration of the first delay line part according to an embodiment of the present invention.

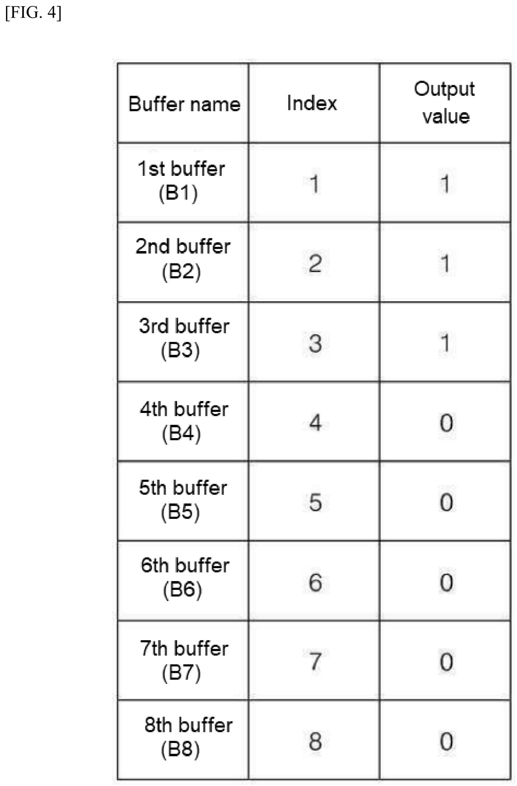

FIG. 4 is a diagram illustrating indexes of buffers in FIG. 3.

The first delay line part (20) may include a delay line (D_L) including a plurality of buffers (delay elements) (B) and D-flip-flops (FF) tapped at output terminals of each buffer (B) of the delay line.

The plurality of buffers may be connected in a cascade manner. That is, the plurality of buffers may be arranged in the order in which the input pulse (P1) flows.

A waveform (Signal) of the input pulse (P1) in FIG. 3 may be outputted from an output terminal of each buffer (B) with a predetermined delay. That is, an output value of a first buffer (B1) is outputted with a predetermined delay from the output terminal of the first buffer (B1), and the output terminal of the first buffer (B1) is connected to an input terminal of a second buffer (B2). The output value (e.g., '1') of the first buffer (B1) may also be inputted to a first flip-flop (FF1).

In this case, a data path delay may occur between each buffer (B) and while passing through the flip-flop (FF). For example, a delay of d1 may occur until an input value ('1') of the first buffer (B1) is delivered to the second buffer (B2), and a delay of d11 may occur until an output value ('1') of the first buffer (B1) is delivered to the first flip-flop (FF1). Similarly, a delay occurs each time data is transferred from a previous buffer to a next buffer, and a delay occurs each time data is transferred from any buffer to a flip-flop connected to the buffer.

FIG. 4 is a diagram illustrating buffer indexes according to an embodiment of the present invention.

Each field of the table in FIG. 4 shows a buffer name, an index, and an output value of the buffer.

Each buffer may be assigned an index defining the order of each buffer. For example, index '1' may be assigned to the first buffer (B1), index '2' may be assigned to the second buffer (B2), and similarly, index '8' may be assigned to the eighth buffer (B8). As described above, when each buffer (B) is arranged in the order in which the input pulse (P1) flows, and the index is arranged according to the order, indices from 1 to 1000 may be assigned to, for example, 1000 buffers, respectively.

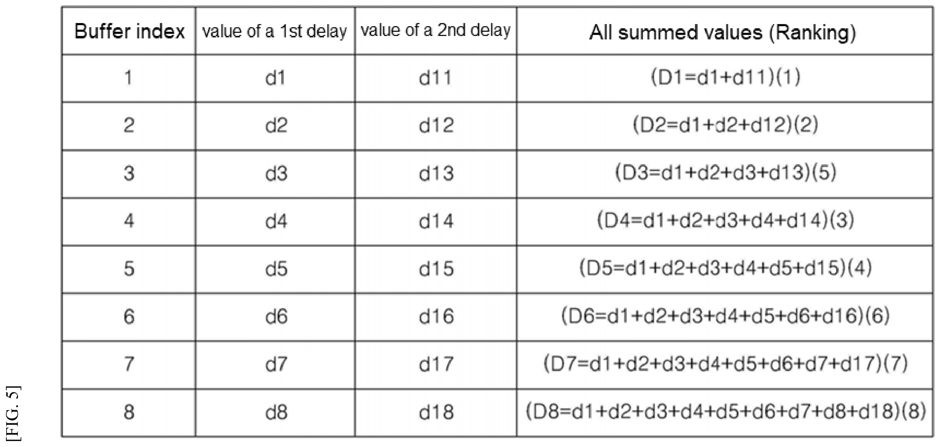

FIG. 5 is a table illustrating data path delays according to an embodiment of the present invention.

Referring to FIGS. 1 and 5, the code conversion part (30) may convert and output the order of elements of the thermometer code (O1) outputted from the first delay line part (20) (e.g., 11100000) (e.g., 1, 2, 3, 4, 5, 6, 7, 8). In this case, a code (e.g., 11010000) outputted by the code conversion part (30) (the order of indexes of corresponding buffers is 1, 2, 4, 5, 3, 6, 7, 8) may be referred to as a 'conversion code (CO1)'.

The conversion code (CO1) outputted by the code conversion part (30) may be a value in which the order of the elements of the thermometer code (O1) is arranged according to a predetermined criterion. In this case, the predetermined criterion may be a data path delay from the output node (N1) of the input pulse (P1) to output nodes (N2) of each of the plurality of flip-flops (FF) included in the first delay line part (20). This will be described in detail with reference to FIG. 5.

Each field of the table shown in FIG. 5 may show a buffer index number, a value of a first delay, a value of a second delay, and a sum value (rank). In this case, the rank may represent a rank for all sum values. In this case, a buffer having the smallest sum value may have rank 1 and a buffer having the largest sum value may have a last rank. Alternatively, the opposite is also possible in other embodiments.

As described above with reference to FIG. 3, the sum value may mean a time taken for data to be delivered from the node (N1) from which the input pulse (P1) is outputted to an arbitrary flip-flop (e.g., FF4).

In this case, a first delay value, which is a time taken for an input value of an arbitrary buffer to be delivered to another buffer continuous with the arbitrary buffer, and a second delay value, which is a time taken for an output value of the arbitrary buffer to be delivered to an input of a flip-flop connected to the arbitrary buffer, may occur.

In this case, a value obtained by adding the first delay value and the second delay value for each buffer may be referred to as a data path delay.

Referring to FIGS. 3 and 5 together, when indexes of each buffer are listed in order, a rank of the sum value of the first delay value and the second delay value may be different from a rank of the number of the index of each buffer. For example, in the case of a third buffer, since a buffer array rank is 3rd, the index number is '3', but the rank of the sum value may be '5'. In detail, in order for data to be delivered to a third flip-flop (FF3), it is necessary to pass through a first buffer (B1), a second buffer, and a third buffer. In this case, a predetermined delay (d1, d2, d3) occurs each time the first buffer (B1), the second buffer (B2), and the third buffer (B3) pass, and a delay (d13) until data outputted from the third buffer (B3) is outputted as an output value of the third flip-flop (FF3) also occurs. That is, a delay until data is delivered from the output node (N1) of the input pulse (P1) to the output node (N2, N23) of the third flip-flop (FF3) may be a value obtained by adding d1, d2, d3, and d13.

As described above, a delay (i.e., a sum value) until data is delivered to the output node of each flip-flop (FF3) can be calculated.

For example, in the present embodiment, a buffer index for the third flip-flop (FF3) is 3, and a buffer index for the fourth flip-flop (FF4) is 4. That is, the fourth flip-flop (FF3) must pass through one more buffer than the third flip-flop.

Although each is about the same as described above, the code conversion part (30) may convert the order of the elements of the thermometer code (O1) based on the calculated delay (sum value) (e.g., from a smallest sum value).

The conversion code (CO1) outputted by the code conversion part (30) may be provided to the priority encoder part (50).

The priority encoder part (50) can digitalize a thermometer code having a long length. For example, the priority encoder part (50) can convert a thermometer code of 5200 bits into a thermometer code of 13 bits. For example, if the buffer (delay element) (B) and the flip-flop (FF) connected to the buffer are 5200 each in FIG. 3 described above, 5200 consecutive binary number strings are outputted, and this can be expressed as a 13-bit binary number.

That is, the priority encoder part (50) may express a first thermometer code (TC1) of 5200 bits and a second thermometer code (TC2) as output values (CO1) over time of the code conversion part (30) as a 13-bit binary number.

Referring to FIG. 2, the first thermometer code (TC1) is a code outputted by the code conversion part (30) in relation to the rising edge of the input pulse (P1) at a rising edge (E4) of a clock pulse (CK2) first generated after the occurrence of the rising edge (E1) of the input pulse (P1). The first thermometer code (TC1) expressed as 13 bits can be provided as an input of the calculation part (60).

Also, the second thermometer code (TC2) is a code outputted by the code conversion part (30) in relation to the falling edge of the input pulse (P1) at a rising edge (E6) of a clock pulse (CK4) first generated after the occurrence of the falling edge (E2) of the input pulse (P1). The second thermometer code (TC2) expressed as 13 bits may be provided as an input of the calculation part (60).

In this case, a time section of the first thermometer code (TC1) and a time section of the second thermometer code (TC2) may be smaller than a period of the clock pulse (CK).

Referring again to FIGS. 1 and 2, the clock pulse counting part (40) may receive the input pulse (P1) from the input signal generation part (10).

The clock pulse counting part (40) can count the number of clock pulses (CK) generated during the sustainment period (T) of the input pulse (P1). For example, in FIG. 2, since rising edges of clock pulses occurring while the input pulse (P1) is in an ON state are two, such as edges (E4, E5), a counted value may be two.

An output value (Coarse count) of the clock pulse counting part (40), i.e., the counted value, may be provided to the calculation part (60).

Referring to FIGS. 1 and 2, the calculation part (60) may determine a value of the above-described generation time difference using the first thermometer code (TC1), the second thermometer code (TC2), and the number of clock pulses counted. For example, the generation time difference may be 2*Period+TC1-TC2.

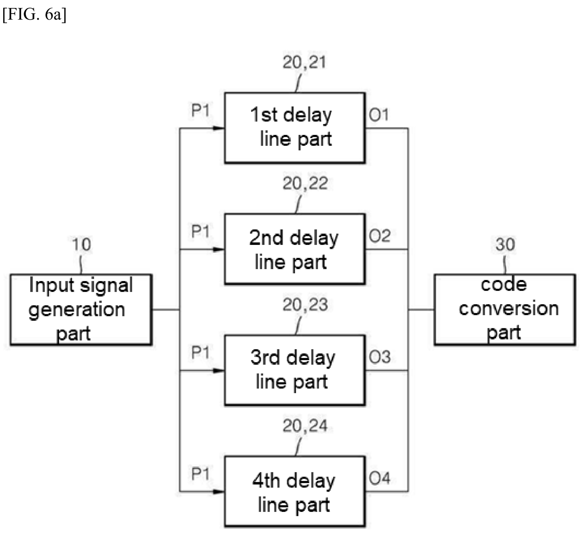

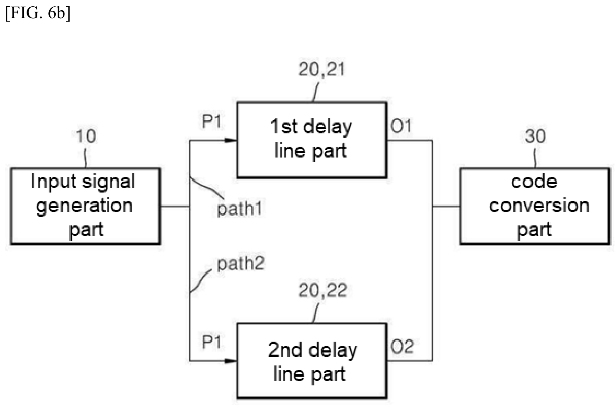

Referring to FIGS. 6A and 6B, the delay line part (20) may be connected in parallel by two or more. In this case, input pulses (P1) outputted from the input signal generation part (10) may be inputted to a first delay line part (21), a second delay line part (22), a third delay line part (23), and a fourth delay line part (24), respectively. Also, a first thermometer code (O1), a second thermometer code (O2), a third thermometer code (O3), and a fourth thermometer code (O4) outputted from the first delay line part (21), the second delay line part (22), the third delay line part (23), and the fourth delay line part (24) may be inputted to the code conversion part (30).

As illustrated in FIG. 6B, it may be assumed that two delay line parts (20) are connected in parallel in another embodiment.

For example, the input pulse (P1) outputted from the input signal generation part (10) may be provided to a first path (path1) in which an output terminal of the input signal generation part (10) and an input terminal of the first delay line part (21) are connected to each other, and a second path (path2) in which an output terminal of the input signal generation part (10) and an input terminal of the second delay line part (22) are connected to each other, respectively.

In this case, times taken for the input pulse (P1) outputted from the input signal generation part (10) to reach the input terminal of the first delay line part (21) and the input terminal of the second delay line part (22) may be different from each other. This is because an input delay exists due to a difference in lengths of the first path (path1) and the second path (path). In the embodiment of FIG. 6B, since a length of the first path (path1) is shorter than a length of the second path (path2), an input time section of an input pulse (path1) through the first path (path1) is smaller than an input time section of an input pulse (path2) through the second path (path2).

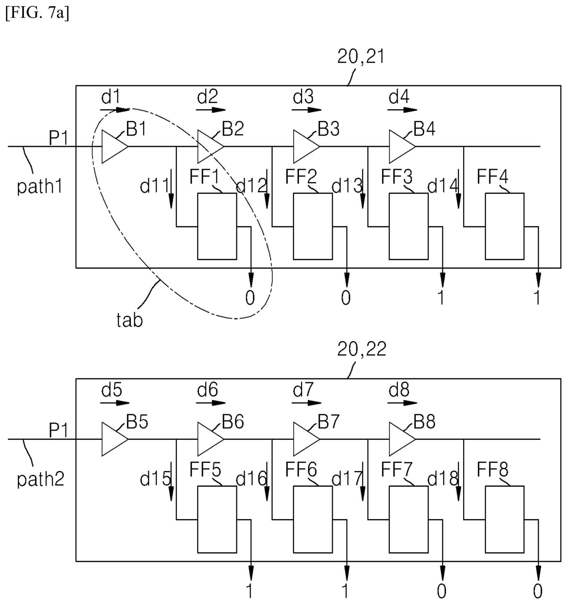

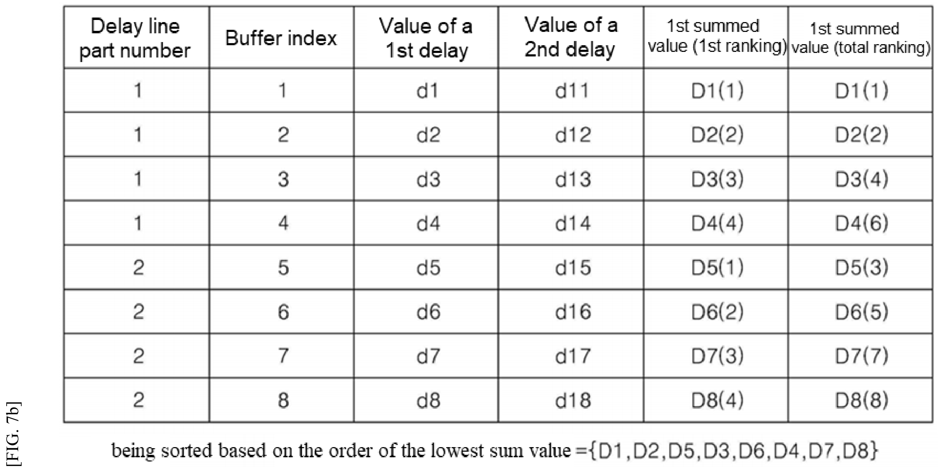

FIG. 7A illustrates configurations of the first and second delay line parts in FIG. 6B, and FIG. 7B illustrates operations of a code conversion part when two delay line parts are used, according to an embodiment of the present invention.

In FIG. 7A, for convenience of explanation, each delay line part is illustrated as including four buffers and flip-flops each.

In FIG. 7B, each field of the table shows a delay line part number, a buffer index number, a value of a first delay, a value of a second delay, a first sum value (first rank), and a first sum value (overall rank). In this case, the first rank may represent a rank for each sum value for buffer indexes in each delay line part. And, the overall rank may represent a rank for each sum value for buffer indexes of all buffers of the first delay line part and the second delay line part. In this case, a buffer having the smallest sum value has rank 1 and a buffer having the largest sum value has a last rank. Alternatively, the opposite is also possible in other embodiments. A method of obtaining the sum value may be the same as described in FIG. 5.

The code conversion part (30) may generate one conversion code by arranging and merging elements of the thermometer code outputted from the first delay line part (21) and buffer index pairs into a first set (e.g., {(D1, 1), (D2, 2), (D3, 3), (D4, 4)}) in which sum values are listed in ascending order, and elements of the thermometer code outputted from the second delay line part (22) and buffer index pairs

and a second set (e.g., {(D5, 5), (D6, 6), (D7, 7), (D8, 8)}) in which sum values are listed in ascending order.

That is, each element of the first set and each element of the second set may be arranged based on an ascending order of sum values.

For example, an output value based on a buffer index in the first delay line part (21) may be {1, 2, 3, 4}, and an output value based on a buffer index in the second delay line part (22) may be {5, 6, 7, 8}. And, in the embodiment of FIGS. 6B and 7A, the delay (d1) may be smaller than the delay (d5).

Therefore, the sorted order may be (D1, 1), (D2, 2), (D5, 5), (D3, 3), (D6, 6), (D4, 4), (D7, 7), (D8, 8). In accordance with the sorted order, output values of flip-flops may be arranged for each buffer index. For example, sorted values (buffer indexes) are 0(1), 0(2), 1(4), 1(6), 1(3), 1(5), 0(7), 0(8).

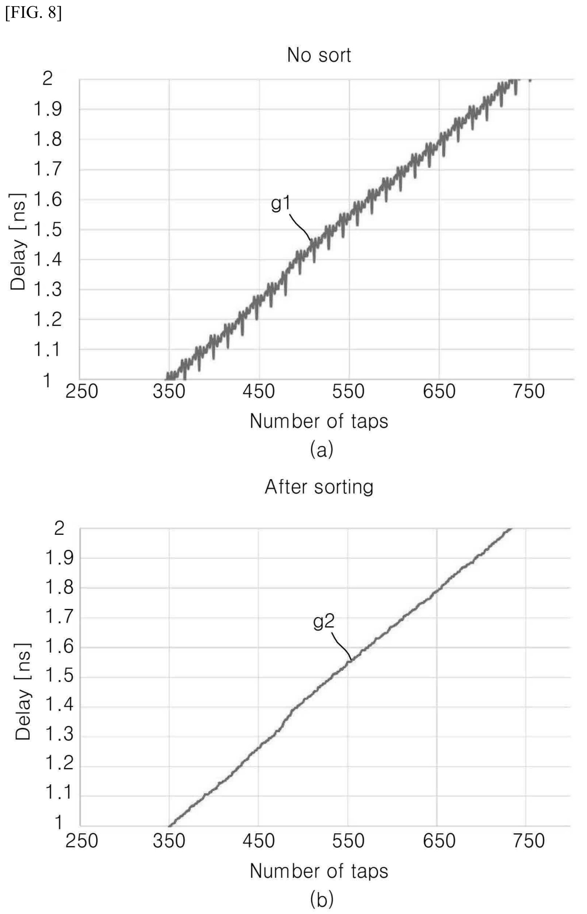

As described above, when a plurality of delay line parts (20) are used, they may have slightly different input delays depending on arrangements. FIG. 8 below shows delays depending on arrangements when a plurality of delay line parts are used.

FIG. 8 is a graph illustrating delays depending on whether a code conversion part is applied or not, according to an embodiment of the present invention.

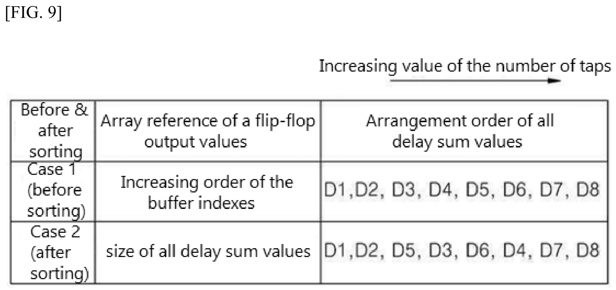

FIG. 9 is a diagram illustrating an array criterion of flip-flop output values and an increase value of the number of taps in FIG. 8 depending on whether a code conversion part is applied or not, according to an embodiment of the present invention.

In FIG. 8, (a) shows a delay diagram according to the number of taps in a state where the code conversion part (30) is not applied, and FIG. 8(b) shows a delay diagram according to the number of taps in a state where the code conversion part (30) is applied.

Fields of the table in FIG. 9 include orders before and after arrangement, an arrangement criterion of flip-flop output values, and an array order of total delay sum values.

Hereinafter, FIGS. 8 and 9 will be described together with reference to FIGS. 8 and 9.

A horizontal axis of graphs (g1, g2) indicates the number of taps (Number of taps). Referring to FIG. 7B, one tap may mean a pair of a buffer (delay element) (e.g., B1) and a flip-flop (FF1) connected to the buffer. For example, if the number of pairs of a buffer and a flip-flop connected thereto is 1000 in total, the total number of taps may be 1000.

A vertical axis of the graphs (g1, g2) indicates a delay time (ns). The delay time may mean a sum of delays until data is delivered to output nodes of each flip-flop tapped at each buffer described in FIG. 5.

The number of taps increases in the graphs (g1, g2). An increase in the number of taps in the graph (g1) may mean, for example, an increase in a buffer index. For example, if the number of taps is 4 in the horizontal axis of the graph (g1), it may mean a buffer index of 4. In this case, a delay value as a vertical axis of the graph (g1) may be D4(=d1+d2+d3+d4+d14) as illustrated in FIG. 7B. For example, if the number of taps is 5, it may mean a buffer index of 5. In this case, a delay value as a vertical axis of the graph (g1) may be D5(=d5+d15) as illustrated in FIG. 7B. In this case, referring to FIG. 9, D4>D5 may be satisfied. Here, a delay observed at the flip-flop of each tap does not always increase as the index of the tap (e.g., index 4 -> index 5) increases, but it can be seen that a case where the delay locally decreases even though the index of the tap increases also occurs.

On the other hand, an increase in the number of taps in the graph (g2) may mean not an increase in a buffer index but an increase in a position according to an arrangement order in a state where output values of each flip-flop are arranged by the code conversion part (30). For example, if the number of taps is 4 in the horizontal axis of the graph (g2), a position order of arranged buffer indexes may be 1, 2, 5, 3, and it may mean a buffer index of 3. And, in this case, a delay value as a vertical axis of the graph (g2) may be D3(=d1+d2+d3+d13). For example, if the number of taps is 5, a position order of arranged buffer indexes may be 1, 2, 5, 3, 6, and it may mean a buffer index of 6. And, in this case, a delay value of this case is D6(=d5+d6+d16). In this case, referring to FIG. 9, D3<D6 may be satisfied.

That is, as illustrated in FIG. 8(a), in a case where the code conversion part (30) of the present invention is not applied, it can be seen that the graph (g1) for a delay depending on an increase in the number of taps does not exhibit a monotonic increase property. On the other hand, as illustrated in FIG. 8(b), in a case where the code conversion part (30) of the present invention is applied, it can be seen that the graph (g2) for a delay depending on an increase in the number of taps exhibits a non-decreasing increase phenomenon.

For example, unlike a custom semiconductor ASIC, an FPGA, which allows direct design through programming, can change functions of a chip according to programming. Therefore, unlike ASIC, functions of each component included in the FPGA may be changed (or depending on arrangements of components), and thus, even though the number of taps increases, a delay does not always increase but may decrease locally, and thus, a non-decreasing increase phenomenon may not be exhibited.

However, it can be seen that the code conversion part (30) can compensate for an output of the first delay line part (20) through the graph (g2) as described above.

As described above, when a plurality of delay line parts (20) are used, the code conversion part can provide arrangement of delays through the code conversion part. As a result, it is possible to provide a TDC with high time resolution while compensating for errors due to jitter. For example, when four delay line parts are configured in parallel to have a total of 9600 taps, it is possible to provide a TDC having a resolution of 0.8 ps per tap.

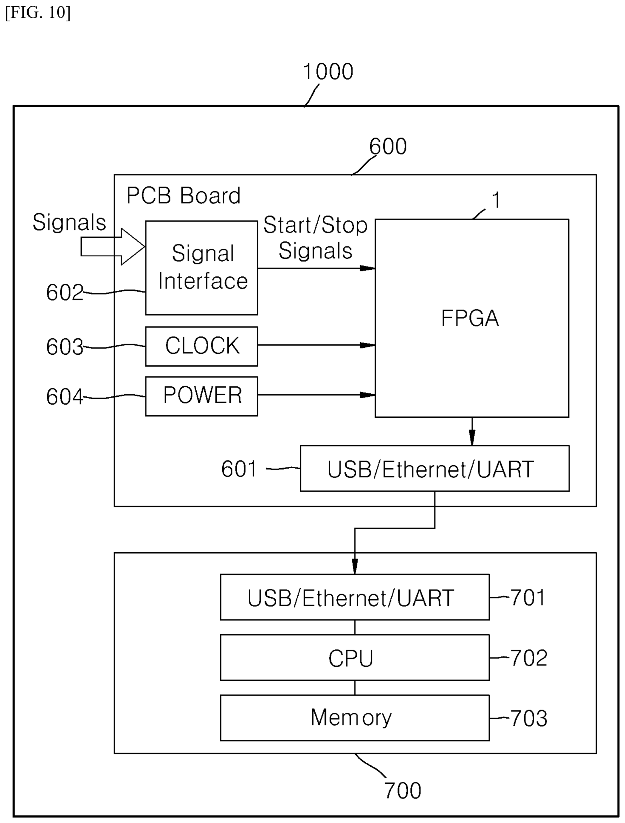

FIG. 10 is a block diagram of a TDC system provided according to an embodiment of the present invention.

A TDC system (1000) may include a PCB board (600) and a computing device (700).

The PCB board (600) is a device capable of processing digital signals and may include the FPGA (1), a data interface (601), a signal interface (602), a clock generation unit (603), and a power supply unit (604) described above.

The data interface (601) is a device that enables data exchange between the PCB board (600) and the computing device (700), and may be configured as USB, Ethernet, or UART, but is not limited thereto.

The signal interface (602) has a function of receiving signals from the outside to measure a time difference using the FPGA (1) and transmitting the signals to the FPGA (1).

The clock generation unit (603) may provide a train of clock pulses counted by the FPGA (1).

A time difference value of two selected signals calculated by the FPGA (1) may be outputted from the FPGA (1) and provided to the data interface (601). The data interface (601) may provide the time difference value of the two signals to the computing device (700).

The power supply unit (104) supplies power used in the PCB board (600).

The computing device (700) may include a data interface (701), a CPU (702), and a memory (703).

The computing device (700) may be configured to perform predetermined algorithms planned in advance using the time difference value of two selected signals received from the PCB board (600). The received time difference value of two signals may be processed by a process executed in the CPU (702). A program configured with commands for executing the process may be stored in the memory (703). The program may be loaded from the memory (703) to the CPU (702) and executed. The memory (703) may be a non-volatile memory.

Using the embodiments of the present invention described above, those skilled in the art to which the present invention pertains will be able to easily implement various changes and modifications within a range not departing from the essential characteristics of the present invention. Therefore, the scope of claims is not limited to the embodiments described in the specification, and should be interpreted based on the scope of the claims and their equivalents.

### [Description of Symbols]

1: FPGA
10: Input signal generation part
20: First delay line part
30: Code conversion part
40: Clock pulse counting part
50: Priority encoder part
60: Calculation part
600: PCB board
700: Computing device
1000: TDC system

## Claims

1. An FPGA, comprising:
a first delay line part (20) to which an input pulse having a width corresponding to a time difference between generation times of a start signal and a stop signal is inputted;
a code conversion part (30) that converts and outputs an order of elements of a thermometer code outputted from the first delay line part; and
a calculation part (60) that determines the generation time difference using a conversion code outputted from the code conversion part,
wherein the conversion code is an arrangement of an order of elements of the thermometer code according to a predetermined criterion, and
the predetermined criterion is a data path delay from an output node of the input pulse to output nodes of each of a plurality of flip-flops (FF) included in the first delay line part.

2. The FPGA, according to claim 1, further comprising:
a second delay line part to which the input pulse is inputted,
wherein the code conversion part is configured to generate the conversion code by arranging and merging elements of the thermometer code outputted from the first delay line part and elements of the thermometer code outputted from the second delay line part according to a predetermined second criterion, and
the predetermined second criterion is a data path delay from an output node of the input pulse to output nodes of each of a plurality of flip-flops included in the first delay line part and the second delay line part.

3. The FPGA, according to claim 1 or 2, further comprising:
an input signal generation part (10) that generates an input pulse having a width corresponding to a time difference between a rising edge of the start signal and a rising edge of the stop signal;
a clock pulse counting part (40) that counts the number of clock pulses generated during a sustainment period of the input pulse; and
the calculation part further includes:
a first thermometer code (TC1) outputted by the code conversion part at a rising edge of a first clock pulse among the generated clock pulses, a second thermometer code (TC2) outputted by the code conversion part at a rising edge of a clock pulse generated immediately after a last clock pulse among the generated clock pulses, and a calculation part that determines a value of the generation time difference using the number of counted clock pulses.

4. The FPGA, according to claim 1,
wherein the FPGA is programmed to include a plurality of delay line parts to which the input pulse is inputted,
the plurality of delay line parts include the first delay line part,
the conversion code outputted from the code conversion part is generated by merging a plurality of thermometer codes outputted from the plurality of delay line parts,
the conversion code is an arrangement of an order of elements of the plurality of thermometer codes according to a predetermined second criterion, and
the predetermined second criterion is a data path delay from an output node of the input pulse to output nodes of each of a plurality of flip-flops in the plurality of delay line parts.

5. A non-transitory computer-readable storage medium, in which an FPGA is programmed to implement a digital circuit comprising:
a first delay line part (20) to which an input pulse having a width corresponding to a time difference between generation times of a start signal and a stop signal is inputted;
a code conversion part (30) that converts and outputs an order of elements of a thermometer code outputted from the first delay line part; and
a calculation part (60) that determines the generation time difference using a conversion code outputted from the code conversion part,
wherein configuration data for programming the FPGA to implement the digital circuit is recorded in a binary file,
the conversion code is an arrangement of an order of elements of the thermometer code according to a predetermined criterion, and
the predetermined criterion is a data path delay from an output node of the input pulse to output nodes of each of a plurality of flip-flops (FF) included in the first delay line part.

6. The non-transitory computer-readable storage medium, according to claim 5,
wherein the digital circuit further comprises:
a second delay line part to which the input pulse is inputted,
the code conversion part is configured to generate the conversion code by arranging and merging elements of the thermometer code outputted from the first delay line part and elements of the thermometer code outputted from the second delay line part according to a predetermined second criterion, and

7. The non-transitory computer-readable storage medium, according to claim 5 or 6,
wherein the digital part further comprises:
an input signal generation part (10) that generates an input pulse having a width corresponding to a time difference between a rising edge of the start signal and a rising edge of the stop signal;
a clock pulse counting part (40) that counts the number of clock pulses generated during a sustainment period of the input pulse; and
the calculation part further comprises:
a first thermometer code (TC1) outputted by the code conversion part at a rising edge of a first clock pulse among the generated clock pulses, a second thermometer code (TC2) outputted by the code conversion part at a rising edge of a clock pulse generated immediately after a last clock pulse among the generated clock pulses, and a calculation part that determines a value of the generation time difference using the number of counted clock pulses.

8. The non-transitory computer-readable storage medium, according to claim 5,
wherein the digital circuit includes a plurality of delay line parts to which the input pulse is inputted,
the plurality of delay line parts include the first delay line part,
the conversion code outputted from the code conversion part is generated by merging a plurality of thermometer codes outputted from the plurality of delay line parts,
the conversion code is an arrangement of an order of elements of the plurality of thermometer codes according to a predetermined second criterion, and
the predetermined second criterion is a data path delay from an output node of the input pulse to output nodes of each of a plurality of flip-flops in the plurality of delay line parts.

9. A TDC system, comprising:
a PCB board (100) including the FPGA (1) according to any one of claims 1 to 4; and
a computing device (200) that acquires the generation time difference from the PCB board.
